# FASCICULE DE BREVET EUROPEEN

(11) **EP 3 094 386 B1**
(45) Date de publication et mention de la délivrance du brevet: **09.05.2018**
(21) Numéro de dépôt: 14827826.0
(22) Date de dépôt: 12.12.2014
(51) Int. Cl.: A63B 24/00, A63B 39/00, A63B 43/00, H01L 41/113, H02N 2/18

(54) **DISPOSITIF A COQUE DEFORMABLE COMPRENANT UN CIRCUIT INTERNE PIEZOELECTRIQUE**
VORRICHTUNG MIT VERFORMBARER SCHALE MIT INTERNER PIEZOELEKTRISCHER SCHALTUNG
DEVICE WITH DEFORMABLE SHELL INCLUDING AN INTERNAL PIEZOELECTRIC CIRCUIT

(30) Priorité: 15.01.2014 FR 1450299
(43) Date de publication de la demande: 23.11.2016
(73) Titulaire: Commissariat à l'Énergie Atomique et aux Énergies Alternatives, 75015 Paris (FR)
(72) Inventeur: SAVELLI, Guillaume, F-38000 Grenoble (FR); CORONEL, Philippe, F-38530 Barraux (FR); HUGUET, Thomas, F-38400 Saint Martin D'heres (FR)
(74) Mandataire: Cabinet Laurent & Charras
(86) Numéro de dépôt international: PCT/FR2014/053307
(87) Numéro de publication internationale: WO 2015/107277

(56) Documents cités:
- WO-A1-2007/052206
- WO-A2-2005/044396
- DE-A1-102007 013 025
- JP-A- H11 267 248
- US-A1- 2011 118 062

## Description

### DOMAINE DE L'INVENTION

L'invention a trait au domaine de la fonctionnalisation de balles et ballons, en particulier les balles et ballons déformables, notamment dans le domaine du sport et/ou de la rééducation physique et/ou de loisir, comme par exemple les balles de tennis.

### ETAT DE LA TECHNIQUE

Dans les sports de balle et de ballon et la rééducation physique à base de tels objets, il est utile de disposer de statistiques qui permettent aux joueurs d'analyser leur jeu et au personnel médical d'évaluer la qualité des exercices pratiqués par les patients. Usuellement, ces statistiques sont collectées manuellement en comptant par exemple le nombre de frappes, rebonds ou autres qu'un joueur ou un patient exerce sur une balle pendant une durée prédéterminée.

Il existe ainsi un intérêt à intégrer dans les balles et les ballons des fonctions électroniques permettant de réaliser automatiquement des statistiques et/ou de convertir et stocker l'énergie mécanique prodiguée à ces objets lors de leur utilisation en énergie électrique.

On connait du document US 2011/136603 une balle de sport comportant une coque déformable délimitant un volume interne sous pression, comme par exemple une balle de tennis, et comportant un élément piézoélectrique disposé sur ou dans la coque déformable pour convertir l'énergie mécanique correspondant à la déformation de la coque en énergie électrique, et un circuit électronique comportant une batterie pour stockage de l'énergie électrique ainsi produite et un circuit de traitement alimenté par la batterie, comme par exemple un accéléromètre, un capteur de pression ou un système GPS.

Ce document est cependant muet sur la manière d'intégrer ces différents composants dans la balle. Or, cette intégration vise généralement plusieurs objectifs qui peuvent être contradictoires.

Tout d'abord, il est recherché un taux de conversion de l'énergie mécanique en énergie électrique élevé car l'énergie électrique peut servir à alimenter des circuits électroniques requérant un niveau élevé d'énergie pour fonctionner.

Ensuite, les composants intégrés dans la balle doivent gêner au minimum son aérodynamique et ses déformations, car il est recherché une balle fonctionnalisée dont les caractéristiques mécaniques sont proches, idéalement identiques, à celles d'une balle classique afin d'être utilisée en lieu et place de celle-ci, notamment dans le domaine sportif dans lequel les balles et les ballons doivent satisfaire des critères très sévères pour être jugés conformes.

Enfin, il est préférable que les composants soient mécaniquement robustes pour faire face à des contraintes mécaniques qui peuvent être élevées en raison des chocs et des accélérations importantes subis par la balle. Les inventeurs ont d'ailleurs noté, dans le cadre d'essais sur différents types de circuit électronique et de connexions électriques intégrés dans une balle de tennis, des casses fréquentes de ces composants. Le document DE 10 2007 013 025 divulgue un dispositif comportant une coque déformable délimitant un volume interne, le dispositif comprenant des ressorts à spirales suspendus dans le volume interne et comprenant deux extrémités solidaires de la coque déformable, un capteur de pression à effet piézoélectrique et un circuit électronique étant suspendus par les ressorts au centre du dispositif.

### EXPOSE DE L'INVENTION

Le but de la présente invention est de proposer un dispositif à coque déformable délimitant un espace interne qui comprend des circuits produisant de l'électricité sous l'effet de déformation de la coque et exploitant ladite production d'électricité à des fins de traitement et/ou de stockage, qui présente un comportement mécanique proche de celui d'un dispositif dépourvu de tels circuits, et dont les circuits sont robustes tout en présentant un taux élevé de conversion de l'énergie mécanique en énergie électrique.

A cet effet, l'invention a pour objet un dispositif comportant une coque déformable délimitant un volume interne, le dispositif comprenant :
- une bande élastique suspendue dans le volume interne et comprenant deux extrémités solidaires de la coque déformable, ladite bande comprenant un matériau piézoélectrique de manière à produire une tension électrique sous l'effet de la déformation de la coque et deux électrodes pour collecter la tension ; et
- un circuit électronique pour traiter la tension, connecté aux électrodes de la bande élastique.

Par « déformable », on entend ici une coque apte à se déformer sous l'effet d'impacts subis par celle-ci au cours d'une utilisation standard de la coque.

En d'autres termes, le dispositif selon l'invention offre un compromis particulier entre les différents objectifs décrits précédemment.

Tout d'abord, la bande élastique se déforme quelle que soit la localisation d'un impact sur la balle ou la direction de l'accélération de celle-ci, ce qui permet d'avoir un taux de conversion minimum de l'énergie mécanique en énergie électrique.

En outre, une bande étant par définition un objet ayant une largeur limitée comparativement à sa longueur, la bande présente une zone de contact limitée avec la coque déformable, ce qui permet de limiter les effets de la bande sur les propriétés de déformation de la coque.

Enfin, le circuit électronique étant disposé directement sur la bande élastique, celui-ci n'est donc pas soumis directement aux impacts au travers de la coque et il n'est pas besoin de connexions électriques de grande longueur, usuellement fragiles, comme cela pourrait être le cas d'un circuit électronique disposé à distance du matériau piézoélectrique. De plus, si la bande élastique est placée sur un plan de symétrie de la coque, le circuit électronique modifie alors de manière minimisée le comportement du dispositif.

Selon un mode de réalisation, la bande élastique comporte une couche de support élastique ayant deux faces opposées, et une couche constituée de matériau piézoélectrique disposée sur au moins l'une desdites faces. De cette manière, la fonction d'élasticité, qui transfert l'énergie mécanique subie par la coque au matériau piézoélectrique, et la fonction piézoélectrique sont en grande partie découplées, ce qui permet d'optimiser chacune d'entre elles.

Selon un mode de réalisation, le coefficient d'élasticité de la couche de support est sensiblement identique au coefficient d'élasticité de la coque déformable. Un coefficient d'élasticité, ou « module d'Young », et un coefficient Shore, importants permettent une déformation importante de la bande élastique, et par conséquent une déformation importante du matériau piézoélectrique, et corolairement, une production importante d'électricité. Toutefois, il a été observé un déphasage entre la déformation de la coque déformable et la déformation de la bande élastique d'autant plus important que leurs coefficients d'élasticité sont différents l'un de l'autre. Ce déphasage peut impacter de manière importante le comportement de la coque, notamment lors de rebond. Par exemple. En minimisant la différence de coefficients d'élasticité, ce déphasage est donc minimisé.

Selon un mode de réalisation, le coefficient shore selon l'échelle D de la couche de support est supérieur ou égal à 70 et l'épaisseur de la couche de support est supérieure ou égale à 3 millimètres. En variante, le coefficient shore selon l'échelle D de la couche de support est supérieur ou égal à 70 et le rapport entre la longueur de la couche de support et l'épaisseur de celle-ci est inférieur à 2200. En d'autres termes, ces gammes de valeurs permettent de minimiser l'effet du déphasage précité sur le comportement de la coque tout en assurant une grande déformation de la bande élastique, et donc une grande production d'électricité.

Plus particulièrement, la couche de support est constituée de polyuréthane ou d'éthylène-propylène-diène monomère (« EDPM »), ces matériaux présentant en effet un coefficient shore approprié pour limiter le phénomène de déphasage.

Selon un mode de réalisation, la couche de matériau piézoélectrique est constituée de polymère piézoélectrique, notamment de polyfluorure de vinylidène (« PVDF »), et est recouverte d'une couche de plastique. Le PVDF présente l'avantage d'être à la fois léger, souple et mécaniquement résistant. En outre, il a été constaté que recouvrir la couche piézoélectrique d'un film plastique permet de renforcer la robustesse mécanique de celle-ci, et donc de la rendre moins sensible aux casses pouvant survenir suite à des chocs violents sur la coque déformable.

Selon un mode de réalisation, la coque déformable et la bande élastique comportent chacune un plan de symétrie, et les plans de symétrie de la coque déformable et de la bande élastique coïncident, ce qui permet de réduire l'effet de la position d'un impact subi par la coque déformable sur la déformation de la bande élastique, et donc sur la production d'énergie électrique par le matériau piézoélectrique.

Selon un mode de réalisation, la coque déformable est une sphère, et la bande élastique est un parallélépipède rectangle de largueur inférieure à 50% du diamètre de la sphère. Les extrémités de la bande élastique sont notamment logées dans la coque par collage. Or, il est constaté qu'un volume important de colle pour maintenir la bande solidaire de la coque impacte les propriétés mécaniques de la coque. Il a été également constaté qu'en choisissant une largeur inférieure à 50% du diamètre de la coque, cet impact est sensiblement réduit tout en permettant un collage suffisant.

Selon un mode de réalisation, la coque déformable est une sphère et le barycentre de l'ensemble formé de la bande élastique et du circuit électronique est disposé au centre de la sphère. Le barycentre du dispositif est ainsi le même que celui de la coque, ce qui minimise l'impact de la présence de la bande et du circuit électronique sur les propriétés mécaniques du dispositif.

Selon un mode de réalisation, le circuit électronique comporte un élément de stockage d'énergie. L'énergie stockée permet ainsi de faire fonctionner des circuits requérant une puissance électrique importante, comme par exemple des modules d'émission radiofréquence permettant de communiquer avec l'extérieur de la coque.

Plus particulièrement, l'élément de stockage comporte une micro-batterie formée sur un substrat souple ou rigide. Ce type de moyen de stockage d'énergie électrique est très léger, usuellement d'un poids et d'une surface faibles pour une grande capacité de stockage.

Plus particulièrement, le circuit électronique comporte un circuit de production de données à partir de la tension électrique produite par la bande élastique, et un circuit de transmission sans fil desdites données à l'extérieur de la coque déformable, lesdits circuits de production et de transmission étant alimentés par l'élément de stockage d'énergie électrique.

Selon un mode de réalisation, le circuit électronique comporte un circuit de détermination de la force exercée sur la coque déformable en fonction de l'amplitude de la tension produite par la bande élastique. Il a été en effet constaté qu'il existe une relation de bijectivité entre l'amplitude de la tension électrique produite et l'amplitude de la force exercée sur la coque déformable. Il est donc possible de déduire cette dernière de la tension produite, par exemple en utilisant un abaque.

### BREVE DESCRIPTION DES FIGURES

L'invention sera mieux comprise à la lecture de la description qui va suivre, donnée uniquement à titre d'exemple, et réalisée en relation avec les dessins annexés dans lesquels :
- la figure 1 est une vue schématique en coupe d'une balle de tennis, présentant une face supérieure d'un système de récupération d'énergie selon l'invention ;
- la figure 2 est une vue schématique en coupe selon le plan II-II de la figure 1 ;
- la figure 3 est une vue schématique en coupe illustrant la flexion d'une bande élastique entrant dans la constitution du système de récupération d'énergie des figures 1 et 2 selon deux positions d'impact sur la balle de tennis ;
- la figure 4 est un tracé illustrant les tensions produites par deux membranes piézoélectriques disposées de part et d'autre de la bande élastique lors d'un impact sur la balle de tennis ;
- la figure 5 est une vue schématique en coupe de la balle de tennis illustrant le déphasage entre le mouvement de la balle de tennis et le mouvement de la bande élastique ; et
- la figure 6 est une vue schématique en coupe d'une membrane piézoélectrique entrant dans la constitution du système de récupération d'énergie.

### DESCRIPTION DETAILLEE DE L'INVENTION

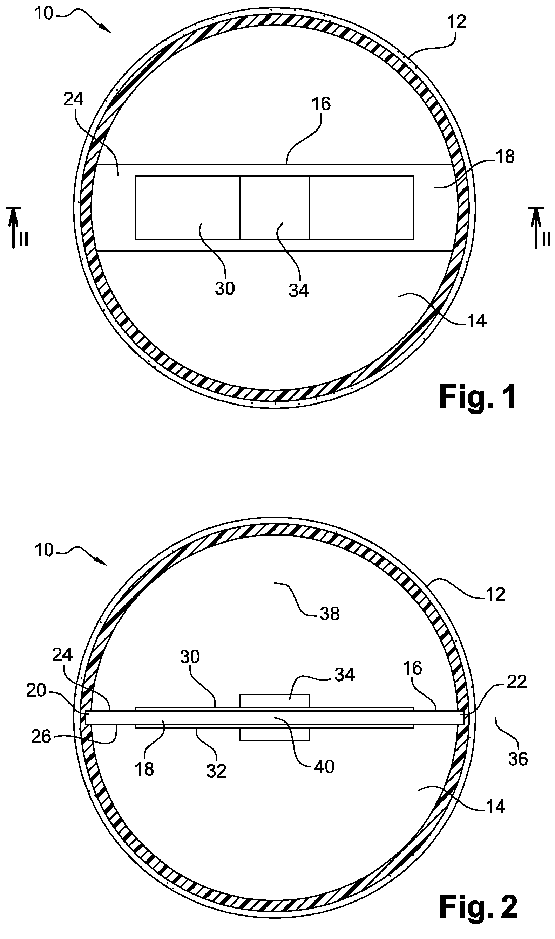

Il va à présent être décrit, en relation avec les figures 1 et 2, une balle de tennis **10** conforme à l'invention. La balle de tennis **10** comprend une coque sphérique déformable **12** définissant un volume interne creux **14.** La coque **12** est par exemple constituée d'une couche de caoutchouc recouverte d'une couche externe de feutrine et le volume interne **14** comporte de l'air sous une pression supérieure à la pression atmosphérique, notamment une pression de l'ordre de 2 bars. La balle de tennis **10** a un diamètre compris entre 6,5 cm et 6,9 cm, et une masse comprise entre 56 grammes et 59 grammes.

La balle de tennis **10** comporte dans le volume **14**, un système de conversion d'énergie et de traitement d'informations **16** comprenant :
- une bande de support **18**, constituée d'un matériau élastique, par exemple du polyuréthane, de l'EDPM, du caoutchouc ou du néoprène. La bande **18** a par exemple la forme d'un parallélépipède rectangle, dont les deux extrémités **20**, **22** sont solidaires de la coque **12**, par exemple en étant logées et collées dans des encoches respectives de la coque **12**, et comprenant deux faces opposées **24**, **26** ;
- une membrane piézoélectrique, **30** et **32** disposée sur une ou chacune des faces **24**, **26** de la bande **18**, solidarisée à ladite face, par exemple par collage, et comportant deux électrodes (non représentées) pour collecter la tension produite par la membrane sous l'effet de la déformation de celle-ci; et
- un circuit électronique **34**, disposé sur l'une et/ou l'autre des faces **24**, **26** de la bande **18**, et solidarisé à la bande, par exemple par collage, le circuit **34** étant électriquement connecté aux électrodes des membranes piézoélectriques **30 et 32**.

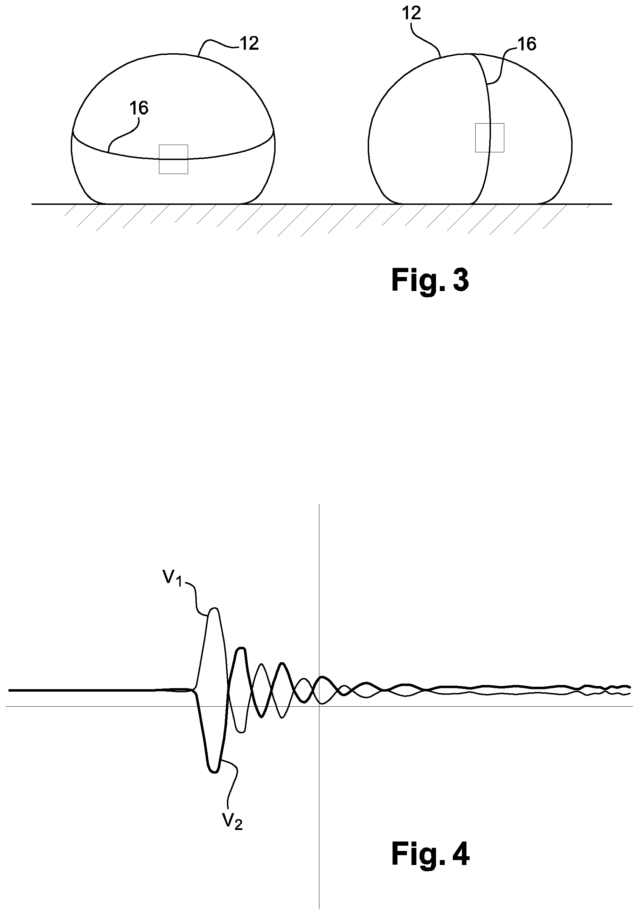

En fonctionnement, comme illustré à la figure 3, lorsque la balle de tennis **10** subit un impact ou une accélération, par exemple un rebond sur le sol, la coque **12** se déforme, ce qui provoque la déformation de la bande élastique **18**, notamment sa flexion. Les membranes piézoélectriques **30 et 32** sont donc également déformées et produisent ainsi une tension électrique aux bornes de leurs électrodes respectives.

La figure 4 est un tracé des tensions V1 et V2 produites respectivement par les membranes piézoélectriques **30 et 32** suite à une frappe sur la balle de tennis **10**, les tensions étant de signes opposés en raison du travail en compression de l'une des membranes pendant que l'autre membrane travaille en tension. L'amplitude du premier pic de la tension est directement reliée à la force exercée sur la balle **10**, les oscillations suivantes correspondants à l'oscillation de la bande **18** jusqu'à son retour à sa position de repos, des tensions d'une amplitude de plusieurs centaines de volts pouvant être obtenues grâce à l'invention, comme cela sera décrit plus en détail par la suite.

Le système **16** est avantageusement optimisé afin que la balle selon l'invention présente un comportement mécanique, notamment en termes de déformation et d'aérodynamisme, proche du comportement d'une balle de tennis classique dépourvue d'un tel système.

Tout d'abord, au repos, le barycentre en masse du système **16** est confondu avec le centre **40** de la balle **10**. Le système **16** présente en outre au moins un plan de symétrie **36**, **38**, confondu avec un plan de symétrie de la balle de tennis **10** passant par le centre **40** de celle-ci. Le système **16** a ainsi une répartition en poids symétrique adaptée à la géométrie sphérique de la balle **10**.

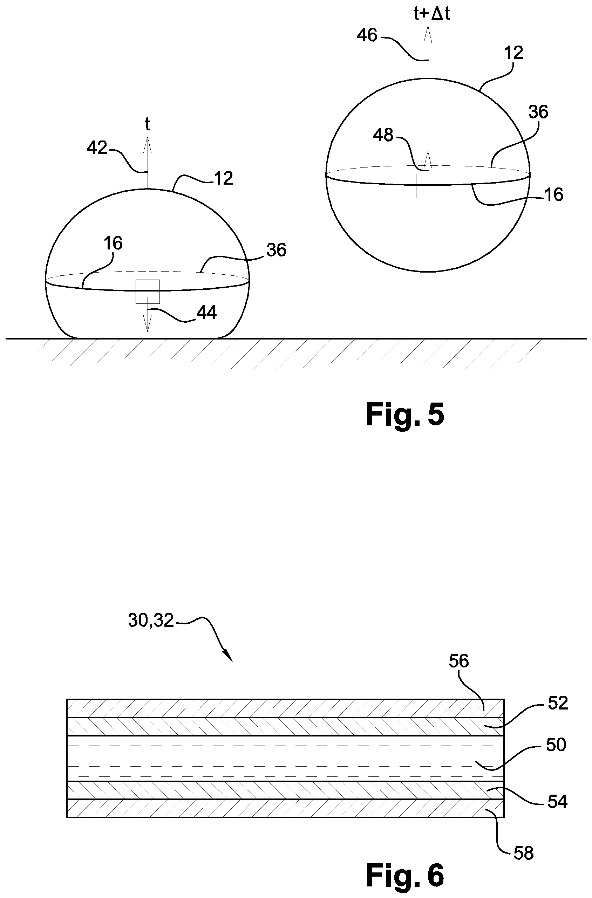

De manière avantageuse, le coefficient d'élasticité de la bande élastique **18** est choisi de manière à minimiser le déphasage entre la déformation de la coque **12** et la déformation de la bande **16**. Comme illustré à la figure 5, lorsque la balle **10** commence à décoller à l'instant « t » de la surface sur laquelle elle a subi un impact, par exemple le sol dans le cas d'un rebond, comme illustré par la flèche **42**, la bande élastique **18** subit encore un mouvement dans une direction opposée, telle qu'illustrée par la flèche **44**, le mouvement de la bande **18** et de la balle **10** présentant la même direction après une durée Δt, comme illustré par les flèches **46**, **48**. Un tel déphasage peut impacter de manière importante le rebond de la balle. Choisir un coefficient d'élasticité et de dureté de la bande élastique **18** proche du coefficient élastique de la coque **12** permet de réduire de manière sensible ce déphasage, et donc d'obtenir un comportement proche d'une balle de tennis classique.

L'amplitude du déphasage dépend également du poids total du système **16**, de sorte que le coefficient d'élasticité de la bande **18** est déterminé en fonction de ce poids. Plus particulièrement, il a été observé qu'une bande constituée d'un matériau de coefficient shore selon l'échelle D supérieur à 70 et d'épaisseur supérieure à 3 mm permet d'obtenir un rebond proche de celui d'une balle dépourvue du système **16**. Il a été observé le même effet pour un coefficient shore selon l'échelle D de la couche de support **18** est supérieur ou égal à 70 et le rapport entre la longueur de la couche de support **18** et l'épaisseur de celle-ci est inférieur à 2200. Par exemple, une bande **18** constituée de polyuréthane, de coefficient shore égal à 80, ou d'EDPM, de coefficient shore égal à 70, d'une largeur de 15 mm et d'une épaisseur de 4 mm permet d'obtenir un rebond supérieur ou égal à 80% du rebond d'une balle.

De préférence, la largeur de la bande **18** est inférieure à 50% du diamètre de la coque **12** de manière à minimiser le volume de bande dans la coque et le volume de colle utilisée pour fixer la bande **18** dans la coque **12**, et par conséquent réduire l'impact de la présence de la bande sur les propriétés de déformation de la coque **12**.

En se référant à la figure 6, les membranes piézoélectriques **30**, **32** comportent chacune :
- un film piézoélectrique **50**, d'une épaisseur avantageusement comprise entre 10 micromètres et 200 micromètres, réalisé en une seule pièce ou en plusieurs pièces;
- deux couches métalliques **52**, **54**, d'une épaisseur de quelques nanomètres à quelques dizaines de micromètres chacune, déposées de part et d'autre du film piézoélectrique **50**, constituées par exemple d'argent, de nitrure de cuivre, d'aluminium, et formant deux électrodes de collecte des charges électriques produites par le film **50** ;
- optionnellement deux couches de renforts flexible **56**, **58**, par exemple en plastique, tel que du polyéthylène téréphtalate (« PET ») ou du polyéthylène naphtalate (« PEN »), déposées respectivement sur les électrodes **52**, **54**.

Avantageusement, le film piézoélectrique **50** est constitué de polyfluorure de vinylidène (« PVDF ») qui présente l'avantage d'être à la fois léger, souple et mécaniquement résistant. En variante, le film **50** est constitué de titano-zirconate de plomb (« PZT »), d'oxyde de zinc (« ZnO »), ou d'un matériau composite d'au moins deux matériaux parmi ceux-ci et le PVDF. Par exemple, les membranes piézoélectriques sont des « DT sensor » fabriqués par la société Measurement Specialities, Inc.

Le circuit électronique **34** met en oeuvre des fonctions d'analyse et de traitement des tensions délivrées par les membranes piézoélectriques **30**, **32** et comporte un élément de stockage d'énergie électrique et un circuit de production de données. Le circuit **34** est notamment conçu pour perturber au minimum le comportement aérodynamique de la balle **10**.

Tout d'abord, le circuit électronique **34** est choisi pour être le plus léger possible compte tenu des fonctions qu'il met en oeuvre. Notamment, l'élément de stockage d'énergie électrique est avantageusement constitué d'une micro-batterie formée sur un substrat souple ou rigide. Par exemple, l'élément de stockage est une micro-batterie à substrat rigide de la gamme « EnerChip » de la société Cymbet® Corp., par exemple une micro-batterie de référence « CBC050-M8C » d'une surface de 8x8 mm² pour une capacité de 50 µAh, ou bien une micro-batterie à substrat souple de la société Solicore®, Inc.,par exemple un micro-batterie de référence « SF-2529-10EC » d'une surface pliable de 25,75x29 mm² pour une capacité de 10 mAh. En variante, l'élément de stockage d'énergie électrique comprend une ou plusieurs capacités et/ou une ou plusieurs super-capacités.

Le circuit de production de données est par exemple un circuit imprimé comprenant une puce électronique équipée d'un microcontrôleur permettant le traitement des données et d'un module d'émission radiofréquence, par exemple selon le protocole ZigBee. Le circuit de production de données est alimenté électriquement par l'élément de stockage d'énergie électrique et/ou d'une batterie intégrée, du type pile « bouton ».

Par exemple, le circuit de production de données réalise une fonction de traitement des impulsions électriques produites par les membranes piézoélectriques **30**, **32** et de production de données relatives auxdites impulsions. Ainsi, le circuit électronique **34** peut comprendre :
- un circuit de comptage du nombre d'impulsions produites depuis la mise en service de la balle de tennis,
- un circuit de détermination de l'intensité moyenne ou individuelle des impulsions,
- et/ou un circuit de détermination de la durée moyenne ou individuelle des impulsions,
- un émetteur radio-fréquence permettant de localiser la balle sur un terrain de tennis, ce qui permet par exemple de savoir si une balle est bonne ou faute,
- un accéléromètre permettant de déterminer la vitesse de la balle.

Les données ainsi produites sont par exemple stockées dans une mémoire interne du circuit **34** et/ou transmises par la communication sans fil à l'extérieur de la balle pour leur collecte.

Notamment, la connaissance du nombre d'impulsions permet de connaître, outre le nombre d'impacts subis par la balle, l'état d'usure de celle-ci, puisque cet état d'usure dépend notamment directement de ce nombre. Le nombre d'impacts, leur intensité et leur durée constituent en outre des données statistiques utiles pour un joueur qui peut ainsi connaître la force de ses frappes et le type de frappes qu'il applique à la balle, etc. Notamment, il a été observé qu'il existe un lien bijectif entre l'amplitude de la première impulsion faisant suite à un impact sur la balle et la force de cet impact. Le circuit de production de données comprend par exemple un abaque mémorisant des valeurs de force en fonction d'amplitude de tension et calcule la force exercée sur la balle en fonction des amplitudes de tensions mémorisées.

De manière avantageuse, le circuit **34** est distribué entre deux parties, disposées de part et d'autre de la bande élastique **18** afin de répartir son poids et obtenir que le barycentre du système **16** soit disposé au centre de la balle et sur un plan de symétrie du système **16**, ce qui permet de réduire la dépendance de la production d'électricité à la position d'un impact sur la coque **12** ou par rapport à la direction d'une accélération subie par la balle **10**. Par exemple, les éléments de stockage d'énergie électrique sont disposés d'un côté de la bande élastique **18**, et le circuit de production de données est disposé de l'autre côté de la bande **18**.

Il a été décrit une balle de tennis. Evidemment, l'invention s'applique à tout type de balles et ballon, et de manière générale à tout objet à coque déformable.

Il a été décrit des applications au sport. Evidemment, l'invention s'applique à d'autres types d'activité, notamment les activités de rééducation physique qui utilisent des balles, des ballons, ou autres, les statistiques produites par de tels objets conformes à l'invention permettant au personnel médical d'étudier par exemple la qualité des exercices suivis par les patients.

## Revendications

1. Dispositif (10) comportant une coque déformable (12) délimitant un volume interne (14), le dispositif comprenant :
- une bande élastique (18, 30, 32) suspendue dans le volume interne (14) et comprenant deux extrémités solidaires de la coque déformable (12), ladite bande (18, 30, 32) comprenant un matériau piézoélectrique (30, 32) de manière à produire une tension électrique sous l'effet de la déformation de la coque (12) et deux électrodes pour collecter la tension ; et
- un circuit électronique (34) pour traiter la tension, disposé sur la bande élastique (18, 30, 32) et connecté aux électrodes de la bande élastique (18, 30, 32).

2. Dispositif selon la revendication 1, dans lequel la bande élastique (18) comporte une couche de support élastique (18) ayant deux faces opposées, et une couche (30, 32) constituée de matériau piézoélectrique disposée sur au moins l'une desdites faces.

3. Dispositif selon la revendication 2, dans lequel le coefficient d'élasticité de la couche de support (18) est sensiblement identique au coefficient d'élasticité de la coque déformable (12).

4. Dispositif selon la revendication 2 ou 3, dans lequel le coefficient shore de la couche de support (18) est supérieur ou égal à 70 et le rapport entre la longueur de la couche de support (18) et l'épaisseur de celle-ci est inférieur à 2200..

5. Dispositif selon la revendication 2, 3 ou 4, dans lequel la couche de support (18) est constituée de polyuréthane ou de éthylène-propylène-diène monomère.

6. Dispositif selon la revendication 2, 3, 4 ou 5, dans lequel la couche de matériau piézoélectrique (30, 32) est constitué de polymère piézoélectrique (50), notamment de polyfluorure de vinylidène, et est recouverte d'une couche de plastique (56, 58).

7. Dispositif selon l'une quelconque des revendications précédentes, dans lequel la coque déformable (12) et la bande élastique (18, 30, 32) comporte chacune un plan de symétrie, et dans lequel les plans de symétrie de la coque déformable et de la bande élastique coïncident.

8. Dispositif selon l'une quelconque des revendications précédentes, dans lequel la coque déformable (12) est une sphère, et dans lequel la bande élastique (18, 30, 32) est un parallélépipède rectangle de largueur inférieure à 50% du diamètre de la sphère.

9. Dispositif selon l'une quelconque des revendications précédentes, dans lequel la coque déformable (12) est une sphère et dans lequel le barycentre de l'ensemble formé de la bande élastique (18, 30, 32) et du circuit électronique (34) est disposé au centre de la sphère.

10. Dispositif selon l'une quelconque des revendications précédentes, dans lequel le circuit électronique (34) comporte un élément de stockage d'énergie électrique.

11. Dispositif selon la revendication 10, dans lequel l'élément de stockage d'énergie électrique comporte une micro-batterie formée sur un substrat souple ou rigide.

12. Dispositif selon la revendication 10 ou 11, dans lequel le circuit électronique (34) comporte un circuit de production de données à partir de la tension électrique produite par la bande élastique, et un circuit de transmission sans fil desdites données à l'extérieur de la coque déformable, lesdits circuits de production et de transmission étant alimentés par l'élément de stockage d'énergie électrique.

13. Dispositif selon l'une quelconque des revendications précédentes, dans lequel le circuit électronique (34) comporte un circuit de détermination de la force exercée sur la coque déformable en fonction de l'amplitude de la tension produite par la bande élastique.

14. Dispositif selon l'une quelconque des revendications précédentes, dans lequel la coque déformable (12) est une balle de tennis.

## Patentansprüche

1. Vorrichtung (10) mit einer verformbaren Schale (12), die einen Innenraum (14) begrenzt, wobei die Vorrichtung folgende Elemente umfasst:
ein elastisches Band (18, 30, 32), das im Innenraum (14) aufgehängt ist und zwei Enden aufweist, die an der verformbaren Schale (12) befestigt sind, wobei das Band (18, 30, 32) ein piezoelektrisches Material (30, 32) zum Erzeugen einer elektrischen Spannung unter der Wirkung der Verformung der Schale (12) und zwei Elektroden zum Sammeln der Spannung enthält; und
eine elektronische Schaltung (34) zum Verarbeiten der Spannung, die auf dem elastischen Band (18, 30, 32) angeordnet und mit den Elektroden des elastischen Bandes (18, 30, 32) verbunden ist.

2. Vorrichtung gemäß Anspruch 1, bei der das elastisches Band (18) eine elastische Trägerschicht (18) mit zwei entgegengesetzten Seiten sowie eine Schicht (30, 32), die aus einem piezoelektrischen Material besteht und die auf mindestens einer dieser Seiten angeordnet ist, aufweist.

3. Vorrichtung gemäß Anspruch 2, bei dem der Elastizitätskoeffizient der Trägerschicht (18) im Wesentlichen mit dem Elastizitätskoeffizienten der verformbaren Schale (12) identisch ist.

4. Vorrichtung gemäß Anspruch 2 oder 3, bei der der Shore-Koeffizient der Trägerschicht (18) größer oder gleich 70 ist und das Verhältnis zwischen der Länge der Trägerschicht (18) und ihrer Dicke kleiner ist als 2.200.

5. Vorrichtung gemäß Anspruch 2, 3 oder 4, bei der die Trägerschicht (18) aus Polyurethan oder Ethylen-Propylen-Dien-Monomer besteht.

6. Vorrichtung gemäß Anspruch 2, 3, 4 oder 5, bei der die piezoelektrische Schicht (30, 32) aus piezoelektrischem Polymer (50), insbesondere aus Polyvinylidenfluorid, besteht, und mit einer Kunststoffschicht (56, 58) bedeckt ist.

7. Vorrichtung gemäß einem der vorstehenden Ansprüche, bei dem die verformbare Schale (12) und das elastische Band (18, 30, 32) jeweils eine Symmetrieebene enthalten und bei dem die Symmetrieebenen der verformbaren Schale und des elastischen Bandes zusammenfallen.

8. Vorrichtung gemäß einem der vorstehenden Ansprüche, bei der die verformbare Schale (12) eine Kugel ist, und bei der das elastische Band (18, 30, 32) ein rechtwinkliges Parallelepiped mit einer Breite von weniger als 50 % des Kugeldurchmessers ist.

9. Vorrichtung gemäß einem der vorstehenden Ansprüche, bei der die verformbare Schale (12) eine Kugel ist, und bei der das Baryzentrum der Einheit aus elastischem Band (18, 30, 32) und der elektronischen Schaltung (34) in der Mitte der Kugel angeordnet ist.

10. Vorrichtung gemäß einem der vorstehenden Ansprüche, bei der die elektronische Schaltung (34) ein Element zur Speicherung der elektrischen Energie enthält.

11. Vorrichtung gemäß Anspruch 10, bei der der das elektrische Energiespeicherelement eine auf einem flexiblen oder starren Substrat gebildete Mikrobatterie enthält.

12. Vorrichtung gemäß Anspruch 10 oder 11, bei der die elektronische Schaltung (34) einen Schaltkreis zur Erzeugung von Daten ausgehend von der vom elastischen Band erzeugten elektrischen Spannung sowie eine Schaltung zur drahtlosen Übertragung dieser Daten nach außerhalb der verformbaren Schale enthält, wobei diese Datenerzeugungs- und Übertragungsschaltkreise vom elektrischen Energiespeicherelement versorgt werden.

13. Vorrichtung gemäß einem der vorstehenden Ansprüche, bei der die elektronische Schaltung (34) einen Schaltkreis zur Bestimmung der Kraft enthält, die auf die verformbare Schale in Abhängigkeit von der Amplitude der vom elastischen Band erzeugten Spannung ausgeübt wird.

14. Vorrichtung gemäß einem der vorstehenden Ansprüche, bei der die verformbaren Schale (12) ein Tennisball ist.

## Claims

1. A device (10) comprising a deformable shell (12) delimiting an inner space (14), the device comprising:
- a resilient band (18, 30, 32) suspended in the inner space (14) and comprising two ends secured to the deformable shell (12), said band (18, 30, 32) comprising a piezoelectric material (30, 32) to generate an electric voltage under the effect of the deformation of the shell (12) and two electrodes for collecting the voltage; and
- an electronic circuit (34) for processing the voltage, arranged on the resilient band (18, 30, 32) and connected to the electrodes of the resilient band (18, 30, 32).

2. The device of claim 1, wherein the resilient band (18) comprises a resilient support layer (18) having two opposite surfaces, and a layer (30, 32) formed of piezoelectric material arranged on at least one of said surfaces.

3. The device of claim 2, wherein the modulus of elasticity of the support layer (18) is substantially identical to the modulus of elasticity of the deformable shell (12).

4. The device of claim 2 or 3, wherein the Shore hardness of the support layer (18) is greater than or equal to 70 and the ratio of the length of the support layer (18) to the thickness thereof is smaller than 2,200.

5. The device of claim 2, 3, or 4, wherein the support layer (18) is made of polyurethane or of ethylene-propylene-diene monomer.

6. The device of claim 2, 3, 4, or 5, wherein the layer of piezoelectric material (30, 32) is made of piezoelectric polymer (50), particularly of polyvinylidene fluoride, and is covered with a plastic layer (56, 58).

7. The device of any of the foregoing claims, wherein the deformable shell (12) and the resilient band (18, 30 32) each comprise a plane of symmetry, and wherein the planes of symmetry of the deformable shell and of the resilient band coincide.

8. The device of any of the foregoing claims, wherein the deformable shell (12) is a sphere, and wherein the resilient band (18, 30, 32) is a cuboid having a width smaller than 50% of the diameter of the sphere.

9. The device of any of the foregoing claims, wherein the deformable shell (12) is a sphere, and wherein the center of mass of the assembly formed of the resilient band (18, 30, 32) and of the electronic circuit is arranged at the center of the sphere.

10. The device of any of the foregoing claims, wherein the electronic circuit (34) comprises an electric energy storage element.

11. The device of claim 10, wherein the electric energy storage element comprises a microbattery formed on a flexible or rigid substrate.

12. The device of claim 10 or 11, wherein the electronic circuit (34) comprises a circuit for generating data from the electric voltage generated by the resilient band, and a circuit of wireless transmission of said data outside of the deformable shell, said generation and transmission circuits being powered by the electric energy storage element.

13. The device of any of the foregoing claims, wherein the electronic circuit (34) comprises a circuit for determining the force exerted on the deformable shell according to the amplitude of the voltage generated by the resilient band.

14. The device of any of the foregoing claims, wherein the deformable shell (12) is a tennis ball.
